# EUROPEAN PATENT APPLICATION

(11) **EP 4 092 848 A1**
(43) Date of publication of application: **23.11.2022**
(21) Application number: 21175109.4
(22) Date of filing: 20.05.2021
(51) Int. Cl.: H01S 5/183, H01S 5/42

(54) **DENSELY PACKED VCSEL ARRAY**

(71) Applicant: TRUMPF Photonic Components GmbH, 89081 Ulm (DE)
(72) Inventor: WEIGL, Alexander, 89312 Günzburg (DE); PRUIJMBOOM, Armand, 89081 Ulm (DE)
(74) Representative: Trumpf Patentabteilung

(57) **Abstract**

The present disclosure relates to the field of Vertical Cavity Surface Emitting Lasers (VCSELs) and in particular to a semiconductor device (1) comprising an array of vertical cavity surface emitting lasers (10, 11, 12, 13), VCSELs, wherein the semiconductor device comprises::a first VCSEL (10) having a first active area (20); a second VCSEL (11) having a second active area (21); a bridge ((31, 31') connecting the first VCSEL and the second VCSEL; wherein the first active area of the first VCSEL and the second active area of the second VCSEL are arranged along a first crystal axis (2); and a blocking structure (41) arranged between the first VCSEL (10) and the second VCSEL (11), wherein the blocking structure is adapted to block a propagation of a defect between the first VCSEL and the second VCSEL along the first crystal axis (2).

## Description

### FIELD OF THE INVENTION

The present invention relates to a semiconductor device comprising an array of Vertical Cavity Surface Emitting Lasers (VCSEL). The present invention further relates to a corresponding method of fabricating such a semiconductor device comprising a VCSEL array.

### BACKGROUND OF THE INVENTION

A vertical-cavity surface-emitting laser or VCSEL is a type of semiconductor laser diode with laser beam emission perpendicular from the top surface. VCSELs can be used as visible and infrared illumination devices for various applications due to the high efficiency, flexible packing options, reliability and various other advantages provided by these semiconductor optical sources. Exemplary applications include, but are not limited to, computer mice, fiber optic communications, laser printers, and optical sensors.

In certain applications, it may be desirable to provide a VCSEL array comprising a plurality of VCSELs. For sensors in mass production, it would be desirable to provide VCSEL arrays that can be manufactured at low cost. Since the manufacturing cost scales with chip area, it would be desirable to provide densely packed VCSEL arrays.

US 2020/0144792 A1 discloses a small pitch VCSEL array. Vertical-cavity surface-emitting lasers (VCSELs) and VCSEL arrays having small size and small pitch are provided. Approaches for reducing the area consumed by a VCSEL structure are described so that a higher density VCSEL device may be achieved. The proposed VCSEL array as described in US 2020/0144792 A1 comprises: a plurality of VCSEL elements, each VCSEL element comprising: an oxide aperture; a mesa concentrically surrounding the oxide aperture, the mesa comprising a round mesa portion and a mesa tab, the mesa tab extending outwardly from the round mesa portion, wherein ohmic metal is provided on the mesa tab; and a nitride via, wherein the nitride via is positioned on the mesa tab, wherein adjacent VCSEL elements have overlapping mesa tabs.

### SUMMARY OF THE INVENTION

It is an object of the present invention to provide a further improved VCSEL array. In particular, it would be advantageous to provide a VCSEL array that is adapted to be manufactured in mass production at low cost with high yield. It would be desirable to provide VCSEL arrays that can be manufactured with high yield at low cost, while at the same time providing high device reliability.

According to a first aspect of the present disclosure a semiconductor device comprising an array of vertical cavity surface emitting lasers, VCSELs, is presented. The semiconductor device comprises: a first VCSEL having a first active area; a second VCSEL having a second active area; wherein the first active area of the first VCSEL and the second active area of the second VCSEL are arranged along a first crystal axis; and a blocking structure arranged between the first VCSEL and the second VCSEL, wherein the blocking structure is adapted to block a propagation of a defect between the first VCSEL and the second VCSEL along the first crystal axis. A bridge may connect the first VCSEL and the second VCSEL. The blocking structure may in particular be adapted to block a propagation of a defect between the active area of the first VCSEL and the active area of the second VCSEL along the first crystal axis.

In a further aspect of the present disclosure a method of fabricating a semiconductor device comprising an array of vertical cavity surface emitting lasers, VCSELs, is presented. The method comprises the steps of: providing a semiconductor die comprising a vertical layer stack adapted for fabrication of VCSELs; determining a crystal axis of the semiconductor die in a direction parallel to a surface of the semiconductor die and perpendicular to the vertical layer stack; processing the semiconductor die into a semiconductor device comprising: a first VCSEL having a first active area; second VCSEL having a second active area; wherein the first active area of the first VCSEL and the second active area of the second VCSEL are arranged along a first crystal axis; and a blocking structure arranged between the first VCSEL and the second VCSEL, wherein the blocking structure is adapted to block a propagation of a defect between the (active area of the) first VCSEL and the (active area of the) second VCSEL along the first crystal axis.

Preferred embodiments of the invention are defined in the dependent claims. It shall be understood that the claimed method may have similar and/or identical preferred embodiments as the claimed semiconductor device, in particular as defined in the dependent claims and as disclosed herein.

The herein presented solutions may provide a possibility provide a further improved VCSEL array that can be manufactured with high yield at low cost, while at the same time providing high device reliability.

The inventors recognized that in densely packed VCSEL arrays, in particular, in densely packed VCSEL arrays with ultra-low pitch of 20-30µm or less, there is a risk that several mesas may suffer from defects. As a peculiarity, the inventors recognized that such defects might affect neighboring VCSELs. While defects of a limited number of individual VCSELs may be tolerated in certain applications, a defect of several neighboring VCSELs may be considered as device failure due to uneven brightness patterns.

The inventors recognized that the probability that neighboring VCSELs that are arranged along a crystal axis suffer from multi-mesa defects is higher than for neighboring VCSELs that are not arranged along the crystal axis. The invention is thus based on the idea to provide specifically provide a blocking structure arranged between neighboring first and second VCSELs that is adapted to block a propagation of a defect between the (active area of the) first VCSEL and the (active area of the) second VCSEL along the first crystal axis. The first VCSEL, the blocking structure and the second VCSEL can thus be arranged on behind the other along the crystal axis such that the blocking structure shields the second VCSEL from defects originating from the first VCSEL that may propagate with higher probability along the crystal axis. A bridge connecting the first and the second VCSEL may still be provided along a path that does not coincide with a straight line along the crystal axis. Hence, a very dense packaging with small pitch can be achieved with only partially etched areas and remaining bridges between neighboring VCSELs.

The feature that the first and the second VCSEL are connected by a bridge (also referred to as ridge or web) means that the material around the emitters is not removed completely, i.e. the first and the second VCSEL are not provided as freestanding mesas, since this would not allow densely packed arrays. For example, the material around the emitters will not be removed completely, just e.g. four areas around emitters may be etched and used for oxidation on the one hand and in view of their advantageous purposeful alignment regarding the crystal axes as blocking structures. An advantageous synergy effect in manufacturing may thus be achieved. The first VCSEL and the second VCSEL may at least partially share a common top contact. The first and second VCSEL are neighboring VCSELs; in particular the neighboring VCSELs closest to each other, in particular in a direction of the first crystal axis. As used herein, the active area of the VCSEL refers to the area of the VCSEL, typically the central portion of the VCSEL, that is adapted for light emission during operation.

The inventors recognized that in an attempt to further reduce the pitch of a VCSEL array, the obvious idea may be to place the oxidation trenches onto the corners of the rows and columns of the grid of a VCSEL array. Thereby an even more compact design may be provided. Small chip sizes allow more chips per wafer and smaller chips can be placed in smaller packages, thereby reducing the overall cost of the chip and package.

However, it has been found that the advantageous effect of reducing multi-mesa defects with the specific arrangement of a blocking structure as described herein can increase the production yield in such a manner that some added chip area and thus higher manufacturing cost may be overcompensated by the higher manufacturing yield. Moreover, depending a number of additional spare VCSELs to provide redundancy in case of failure of individual VCSELs may be reduced. This further reduces the required device area and may further help to reduce power consumption.

The VCSEL array can be an array, in particular a densely packed array, having a pitch of not more than 30µm, in particular not more than 20 µm, in particular not more than 17.5µm, in particular not more than 15µm, in particular not more than 10µm. As used herein the term pitch may refer to a (shortest) center-to-center distance of neighboring VCSELs. The proposed solution is particularly advantageous because at small pitch because it is no longer feasible to completely separate mesas and to provide separate electrical connections. Moreover, the risk of multi-mesa defects increases with increasing VCSEL density.

A width (or length) of the blocking structure in a direction perpendicular to the first crystal axis can wider than a width of first and/or second active area in a direction perpendicular to the first crystal axis. For example, if the blocking structure is provided as a trench between neighboring VCSELs along the first crystal axis, the trench may be wider than a diameter of active area. In view of this orientation, a width of the blocking structure in a direction perpendicular to the first crystal axis may refer to a length of the trench. As used herein, perpendicular to crystal axis means perpendicular to the crystal axis but parallel to top surface of semiconductor die. The first active area, the blocking structure and the second active may be centered with respect to the first crystal axis, such that the blocking structure being wider than the first active area shields a defect originating from the first active area and propagating along the first crystal axis from reaching the second active area.

A width (or thickness) of the blocking structure in a direction parallel to the first crystal axis can be smaller than 30% or the VCSEL pitch, in particular smaller than 20% of the VCSEL pitch, in particular smaller than 10% of the VCSEL pitch, in particular smaller than 5% of the VCSEL pitch. In addition or in the alternative, a width of the blocking structure in a direction parallel to the first crystal axis may be smaller than 10µm, in particular smaller than 5µm, in particular smaller than 3µm, in particular smaller than 2µm. Hence, even a rather narrow trench or blocking structure may effectively reduce multi-mesa defects. In view of this orientation, a width of the blocking structure in a direction parallel to the first crystal axis may refer to a width of the trench. For example, the trench or other blocking structure may be 3µm wide and 10µm long. As used herein, parallel to crystal axis refers to parallel to crystal axis and parallel to top surface of semiconductor die.

As already indicated above, the blocking structure can comprise or be formed by an etched area. In particular, the blocking structure can comprises or be formed by a trench used for oxidation, in particular for oxidation of a respective oxide aperture of the first and/or second VCSEL. An advantage of this embodiment is a synergy effect since the formation of the blocking structure and formation of the oxide aperture may coincide.

It shall be understood that a depth of the etched area may exceed a depth of an active layer of the first and/or second VCSEL. Thereby, the risk of having propagating defects can be substantially reduced.

The etched area can be separated from a top-contact of the first and/or second VCSEL. In particular, the blocking structure may comprises a partially etched area, which may be separated from a top-contact around an active area of the first VCSEL. The top-contact may be a p-contact or n-contact.

The bridge connecting the first VCSEL and the second VCSEL may advantageously bend around a side of the blocking structure. Hence, the bridge does preferably not establish a path between the first and second VCSEL that coincides with the first crystal axis or optionally any crystal axis. In a further refinement, a second bridge connecting the first VCSEL and the second VCSEL may be provided, that bends around a second side of the blocking structure different from the first side. An advantage of this embodiment is that less material needs to be removed and additional structural support may be provided.

The bridge connecting the first VCSEL and the second VCSEL may optionally be a bridge connecting the first VCSEL, the second VCSEL and a third neighboring VCSEL. In a further refinement, the bridge may also connect a fourth neighboring VCSEL. As used herein, connecting VCSELs refers to directly connecting VCSELs, i.e. without going via intermediate further VCSELs or portions thereof.

Referring again to the device geometry, a distance between the first and the second VCSEL may be less than a diameter of the first and/or second active area. This further highlights the aspect that a densely packed array is provided, wherein the VCSELs of the array are very close to each other. A distance between neighboring VCSEL can refer to width of the blocking structure arranged between the first VCSEL and the second VCSEL.

The first and second VCSEL of the array may have a common electrical top contact and/or common electrical bottom contact. The top contact can be p-contact. The bottom contact can be n-contact. Or vice versa. Optionally, a first top contact portion surrounding the active area of the first VCSEL and a second top contact portion surrounding the active area of the second VCSEL may be provided. The first and second top contact portions can be connected via a first bypass contact around a first side of the blocking structure and via a second bypass contact around a second side of the blocking structure. Different electrical pathways between neighboring VCSELs may thus be provided. Such bypass contacts can refer to electrical connections immediately adjacent to and circumventing the blocking structure at both sides.

The VCSEL array of the semiconductor device may of course provide more than two VCSELs. The semiconductor device may further comprise a third VCSEL having a third active area. A second bridge connecting the first VCSEL and the third VCSEL may be provide. The first active area of the first VCSEL and the third active area of the third VCSEL may be arranged along a second crystal axis. A second blocking structure may be arranged between the first VCSEL and the third VCSEL. The blocking structure may be adapted to block a propagation of a defect between the (active area of the) first VCSEL and the (active area of the) third VCSEL along the second crystal axis. This further reduces multi-mesa defects. The first crystal axis may intersect the second crystal axis at an angle between 45° and 135°, in particular between 60° and 120°, in particular between 75° and 105°, in particular between 85° and 95°.

The first VCSEL may have a rectangular, in particular a quadratic active area, and wherein blocking structures are provided on each side of the active area. For example, four blocking structures may be provided around the active area, one on each side respectively. This effectively shields the VCSEL from outside defects and at the same time protects the neighboring VCSELs.

The semiconductor device may comprises a plurality of VCSELs arranged in rows and columns on a rectangular grid, in particular on a quadratic grid. A separate blocking structure is provided between each pair of neighboring VCSELs on the grid. Each blocking structure may be adapted to block a propagation of a defect between the corresponding pair of neighboring VCSELs. The rows of the grid can be aligned with a first crystal axis. The blocking structures along the rows can be adapted to block a propagation of a defect between neighboring VCSELs along the respective rows. The columns of the grid can be aligned with a second crystal axis, different from the first crystal axis. The blocking structures along the columns can be adapted to block a propagation of a defect between neighboring VCSELs along the respective columns.

It is to be understood that the features mentioned above and those yet to be explained below may be used not only in the combination respectively indicated, but also in other combinations or separately, without departing from the scope of the present invention.

### BRIEF DESCRIPTION OF THE DRAWINGS

These and other aspects of the invention will be apparent from and elucidated with reference to the embodiment(s) described hereinafter. In the following drawings
Fig. 1 shows a schematic diagram of an embodiment of a semiconductor device comprising an array of vertical cavity surface emitting lasers, VCSELs, according to an aspect of the present disclosure;
Fig. 2 shows an image of an exemplary semiconductor device according to an aspect of the present disclosure;
Fig. 3A-L illustrate different processing steps of the fabrication process;
Fig. 4A-D show measurement results of an exemplary semiconductor device according to an aspect of the present disclosure;
Fig. 5 shows a schematic diagram with defect propagation;
Fig. 6 shows a flow chart of a method according to an aspect of the present invention.

### DETAILED DESCRIPTION OF THE INVENTION

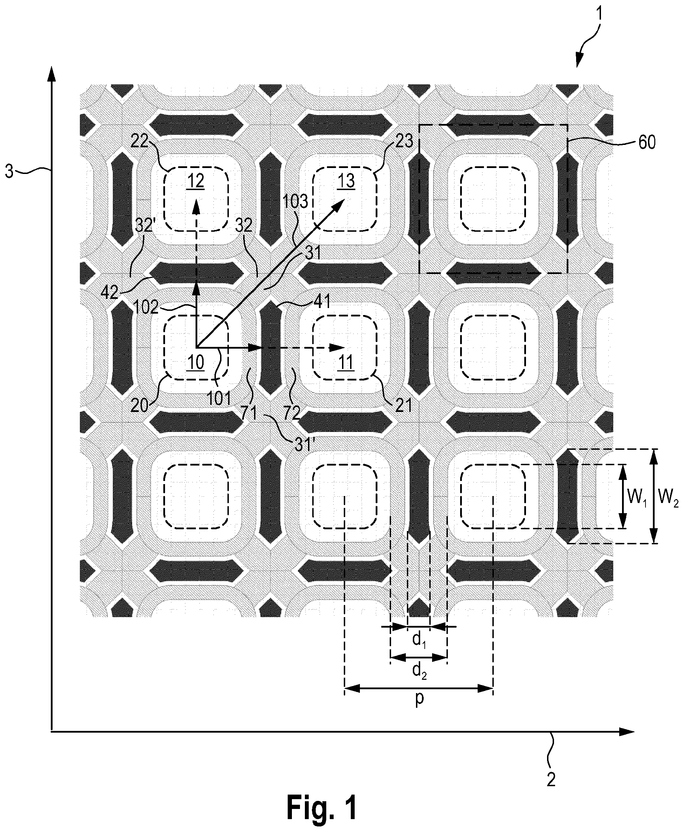

Fig. 1 shows a schematic diagram of an embodiment of a semiconductor device comprising an array of vertical cavity surface emitting lasers, VCSELs. The system is therein denoted in its entirety by reference numeral 1. A first crystal axis of the semiconductor device is denoted by reference numeral 2. An optional second crystal axis is denoted by reference numeral 3. It the given example, the first and second crystal axis may intersect at an angle of 90°. The semiconductor device 1 comprises a first VCSEL 10 having a first active area 20 and a second VCSEL 11 having a second active area 21. A bridge 31, 31' is provided that connects the first VCSEL 10 and the second VCSEL 11. The bridge can be a non-etched portion of the semiconductor material. The first active area 20 of the first VCSEL 10 and the second active area 21 of the second VCSEL 11 are arranged behind each other along the first crystal axis 2. A blocking structure 41, here in form of a trench, is arranged between the first VCSEL 10 and the second VCSEL 11, in particular between the first and second active area 20, 21. The blocking structure is adapted to block a propagation of a defect 101 between the first VCSEL 10 and the second VCSEL 11 along the first crystal axis 2. This is exemplarily illustrated in Fig. 1 by the arrow 101 that is blocked by the trench as the blocking structure 41.

The semiconductor device 1 may optionally comprise further VCSELs as exemplarily illustrated in Fig. 1. Similar to the above, a third VCSEL 12 having a third active area 22 may be provided. A second bridge 32, 32' connects the first VCSEL 10 and the third VCSEL 12. The first active area 20 of the first VCSEL 10 and the third active area 22 of the third VCSEL 12 are arranged along a second crystal axis 2. A second blocking structure 42 is arranged between the first VCSEL 10 and the third VCSEL 12, wherein the blocking structure is adapted to block a propagation of a defect 102 between the first VCSEL 10 and the third VCSEL 12 along the second crystal axis 2. This is exemplarily illustrated in Fig. 1 by the arrow 102 that is blocked by the trench as the blocking structure 42. It should be noted that no blocking structure is provided between the first VCSEL 10 and a fourth VCSEL 13 that is arranged diagonal with respect to the first VCSEL 10. However, the probability of defect propagation along arrow 103 is limited such that this path may be tolerated even for a densely packed array. Moreover, since the diagonal path length is longer, there is a higher probability that a defect originating from the first VCSEL 10 may not reach the second VCSEL 20.

In other words, in case that there may be a defect in one emitter, this defect will propagate in most cases along one of the crystal axes 2, 3. The blocking structure, here provided as etched areas, which are arranged in this direction will stop the propagation of the defect. This will reduce significantly the risk of multi mesa failure. Accordingly, the device reliability and also the manufacturing yield may be further improved.

Advantageously, semiconductor device 1 may comprise several unit cells 60 that may be flexibly combined to provide a VCSEL array having a desired size and shape. The number of rows and/or columns of the VCSEL array may be flexibly adjusted as needed.

Regarding exemplary the geometric dimensions, the VCSEL array can be a densely packed array having a pitch between 8 and 30µm, e.g. 16µm. A narrow trench having a width d1 may be provided as the blocking structure. The width d₁ of the blocking structure in a direction parallel to the first crystal axis 2 may be smaller than 30% or the VCSEL pitch p, in particular smaller than 20% of the VCSEL pitch, in particular smaller than 10% of the VCSEL pitch, in particular smaller than 5% of the VCSEL pitch. In the given example, the trench may be about 3µm narrow. On the other hand, a width w₂ of the blocking structure 31 in a direction perpendicular to the first crystal axis 2 is preferably wider than a width w₁ of first and/or second active area 20, 21 in a direction perpendicular to the first crystal axis 2. Thereby, any defects originating from one of the two active areas can be effectively prevented from reaching the respective other active area. For example, a width w₁ of the active area may be between 3µm and 20µm. A with w₂ of the blocking structure may typically be at least about 10µm. However, for active area widths exceeding 10µm, the width of the blocking structure may be increased accordingly. The distance d₂ between the inner edges of the top contacts of adjacent VCSELs may be at least 5µm, in particular at least 8µm such that there is sufficient space for forming the blocking structure therein between. However, as an upper limit the distance d₂ may be less than 20µm, in particular less than 15µm. This allows to provide compact arrays. In the example shown in Fig. 1, the center-to-center distance between the first VCSEL 10 and the second VCSEL 11 may be about 16µm. Defect propagation along this short distance is effectively blocked by the blocking structure. In an embodiment, the blocking structure may be arranged centered on a line connecting a center of the first VCSL 10 and a center of the second VCSEL 11. In the example shown in Fig. 1, the center-to-center distance between the first VCSEL 10 and the fourth VCSEL 13, i.e. along diagonal line 103, may be about 22.8µm.

As shown in Fig. 1, a bridge 31 connecting the first VCSEL 10 and the second VCSEL 11 may bend around an upper side of the blocking structure 41. Hence, an common electrical connection is established while bypassing a direct path along the crystal axis 2. Optionally, a second bridge 31' connecting the first VCSEL 10 and the second VCSEL 11 may bends around a lower side of the blocking structure 41. The bridges may be shared by a plurality of neighboring VCSELs. As shown in Fig. 1, the bridge 31 connecting the first VCSEL 10 and the second VCSEL 11 may also connect to the third neighboring VCSEL 12 and preferably further to a the fourth neighboring VCSEL 13. Even tough different reference numerals 31 and 32 are shown, this is to be understood as a common bridge structure that is shared among at least three neighboring VCSELs.

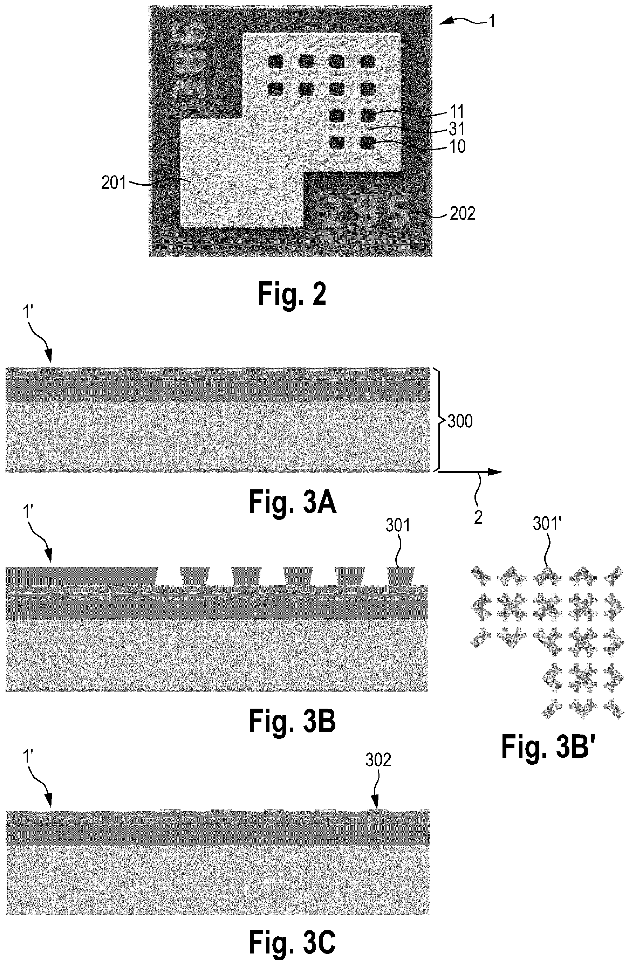

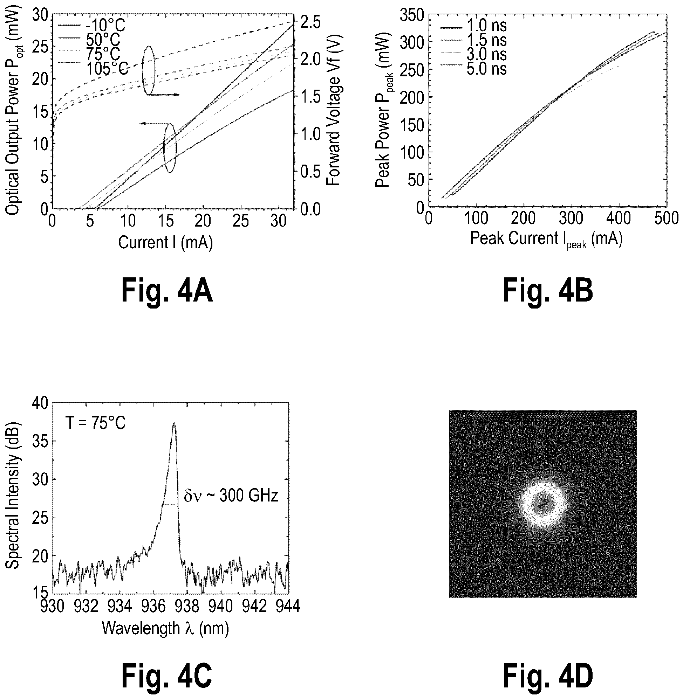

Fig. 2 shows an image of an exemplary semiconductor device 1 according to an aspect of the present disclosure. In the given example, 12 VCSELs are provided that are provided in two rows of four VCSELs followed by two rows of two VCSELs. The first VCSEL 10 and the second VCSEL 11 are again separated by a blocking structure 31 that is adapted to block a propagation of a defect between the first VCSEL 10 and the second VCSEL 12 along the first crystal axis, being aligned with the respective centers of the active areas of the first and second VCSELs 10, 11. A bond pad 201 for providing a first electrical contact to the VCSELs can be seen on the top surface. A back electrode, not shown, may serve as the second electrical contact. Optionally, production markers 202 may be shown on the surface. Additional details about the device will be explained further below with reference to Fig. 4.

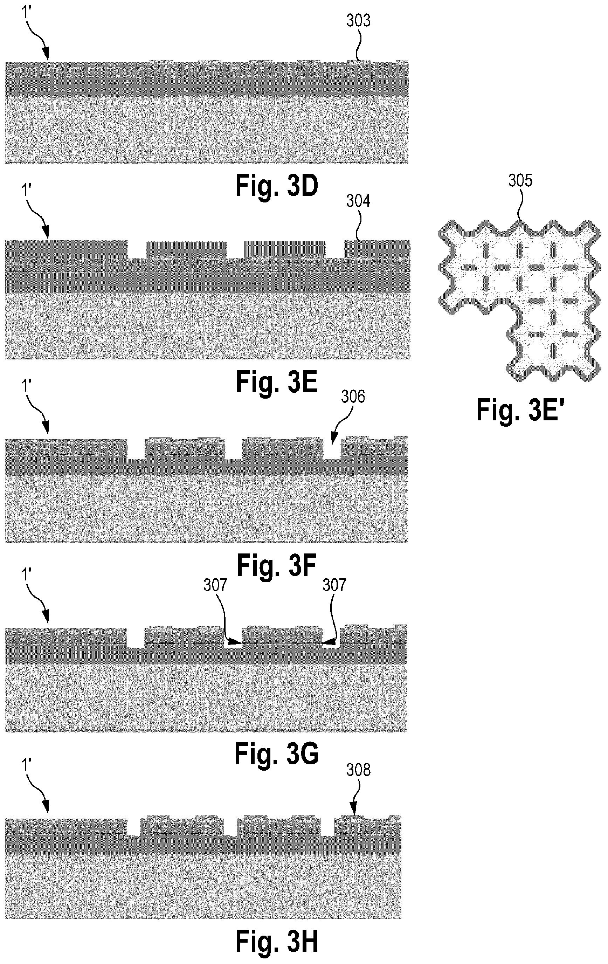

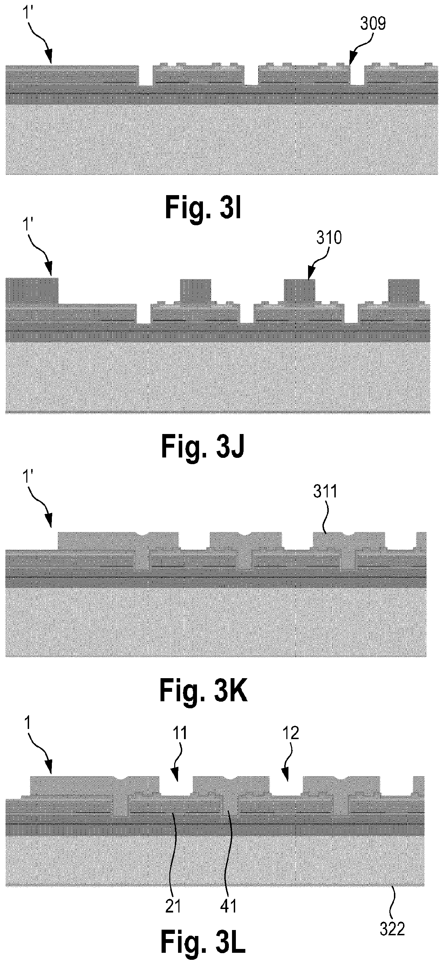

Fig. 3A-L illustrate different processing steps of the fabrication process. The unfinished semiconductor device is denoted by reference numeral 1'. As illustrated in Fig. 3A, a semiconductor die 300 comprising a vertical layer stack adapted for fabrication of VCSELs is provided in a first step. The semiconductor die is arranged such that a crystal axis 2 die in a direction parallel to a surface of the semiconductor die and perpendicular to the vertical layer stack during manufacturing is aligned with the active areas of neighboring VCSELs. Fig. 3B shows the step of p-contact lithography 301 with a mask 301' as shown in Fig. 3B'. Fig. 3C shows the step of p-contact 302 deposition. Fig. 3D shows the step of SiNx deposition layer 303. Fig. 3E shows the step of lithography 304 for mesa etch with a mask 305 as shown in Fig. 3E'. Fig. 3F shows the step of mesa dry etching to form the trenches 306, which on the one hand may serve as oxidation trenches so as to provide an oxide aperture 306 as illustrated in Fig. 3G, but also serve as a blocking structure between the active areas of neighboring VCSELs along the direction of the crystal axis 2. Fig. 3H shows the step of SiNx deposition layer 308. Fig. 3l shows the outcome of via hole etch lithography and seed layer 309 deposition. Fig. 3J illustrated lithography 310 for Au plating. Fig. 3K illustrates the step of Au plating 311. Fig. 3L finally illustrated the result after additional steps such as seed layer removal, street etch in SiNx, bow compensation layer removal and wafer thinning, backside n-contact and bow compensation metal deposition and annealing. The backside contact is dented by reference numeral 322. The first VCSEL 11 and second VCSEL 12 in Fig. 3L are now separated by a blocking structure 41. Defects in the active area 21 of the first VCSEL 11 in Fig. 3L may thus be effectively prevented from propagating to the neighboring second VCSEL along a direction of the first crystal axis 2.

Referring again to Fig. 2 and Fig. 4A-D, an exemplary, non-limiting embodiment is described. A 940nm-emitting VCSEL-array with 12 emitters for high optical output powers is presented. The output characteristics may be adapted to show spectral single-mode behavior as well as a Gaussian-shaped far-field profile. The dense-packed emitter design may measure up to 3850 emitters per mm2 and is easily scalable for high-power applications. The basic structure of the exemplary Vertical-Cavity Surface-Emitting Lasers (VCSELs) allows dense-packaged multi-emitter arrays for high optical output power. As indicated above, an oxidized 940 nm single-mode emitting VCSEL-array with 12 output facets and stable Gaussian far-field beam profile for various driving conditions and temperatures can be provided. At short pulsed condition peak single-mode output powers up to 300 mW (>25 mW per emitter) cloud be demonstrated. Advantageously, the outstanding device-reliability allows for industrial Time-of-Flight (ToF) applications at an extensive temperature range.

In an embodiment, a GaAs-based epitaxial layer structure can be provided that includes a GaAsP active zone for ultraviolet 940 nm output characteristics using oxide confinement to maintain spectral single-mode behavior. The chip design is depicted in Fig. 2, where the 12 emission windows are clearly visible as openings in the Gold-plated electrical top contact, including a bond pad 201 on the bottom left in the picture at an exemplary diced chip size of 187 x 187 µm. The chip backside can be wafer-thinned and gold-covered and serves as electrical bottom contact, see 322 in Fig. 3L.

Light-current-voltage (LIV) measurements of the exemplary VCSEL-array chip are shown in Fig. 4A. It can be seen that the thermal roll-over at the output power is not yet reached at currents higher than 30 mA. The slope efficiency at 50°C is 0.90 W/A with a threshold current between 3 mA or 6 mA, depending on the ambient temperature. Compared to single-mode VCSELs with similar optical aperture using epitaxial regrowth, the optical output power of the oxidized 12 emitter VCSEL-array may even be higher. High-power concepts as multi-junction VCSELs require more forward voltage and do not provide single-mode emission.

As shown in Fig. 4B, using short pulsed conditions in the ns-range, the peak output power may increase above 300 mW (> 25 mW per emitter) while maintaining a slope efficiency of 0.75 W/A at room temperature. The output power can even be further increased by scaling up to larger chips with identical emitter-per-area density. For a chip size of 0.97 mm2 and 2352 emitters, a slope efficiency of around 1 W/A may be reached by using pulsed operation with 200 µs pulse width and 10% duty-cycle. This may results in 4 W output power at 5 A current flow.

As illustrated in Fig. 4C, the spectral measurement of the 12 emitter VCSEL-array may show single-mode behavior at 75°C temperature with a bandwidth at FWHM of 300 GHz and a peak wavelength of circa 937 nm. It is expected, that with improved spectral resolution, the narrow-bandwidth spectrum of each emitter may appear. As the right picture of Fig. 4D indicates, the interference of all emitters may results in a Gaussian-shaped far-field characteristic. In the given example, the divergence angles at 50°C are around 17°, with a small temperature drift of only -0.015°/°C in the range between 25 and 105°C. It should be mentioned, that even at short-pulsed operation mode in the ns-range, the transversal mode behavior may remain constantly Gaussian shaped.

A reliability measurement of a set of exemplary devices that implement the proposed solution shows remarkable results. After a test time of 3300 h at cw-operation, no failures appear at conditions lower than 32.5 mA current flow and 120°C. While testing under more extreme conditions as 40 mA, 120°C and 25 mA, 150°C, the very first failures occur only after 600 h, respectively 1200 h. Calculations for the time to 1%-failure at stressed used conditions as 25 mA and 105°C offers a device lifetime of more than 16000 hours, creating a benchmark for high-power single-mode devices. In particular, multi-mesa defects may be drastically reduced. This is particularly advantageous in application scenarios wherein single VCSEL failures may be tolerated.

The exemplary device illustrated in Fig. 2 and described with reference to the experimental results of fig. 4A-D thus provides a single-mode VCSEL array with 12 top emitters for high single-mode optical output power up to 25 mW at 30 mA at low forward voltage without thermal roll-over. The output power can be further increased by short-pulsing the device up to 25 mW per emitter or scaling up the dense-packed emitter area, thus power values in the Watt-range are achievable. The 12-emitter device convinces with low divergence angle without higher transversal modes even at short-pulsed conditions. The superb reliability-characteristics of the device qualifies for long-live industrial applications.

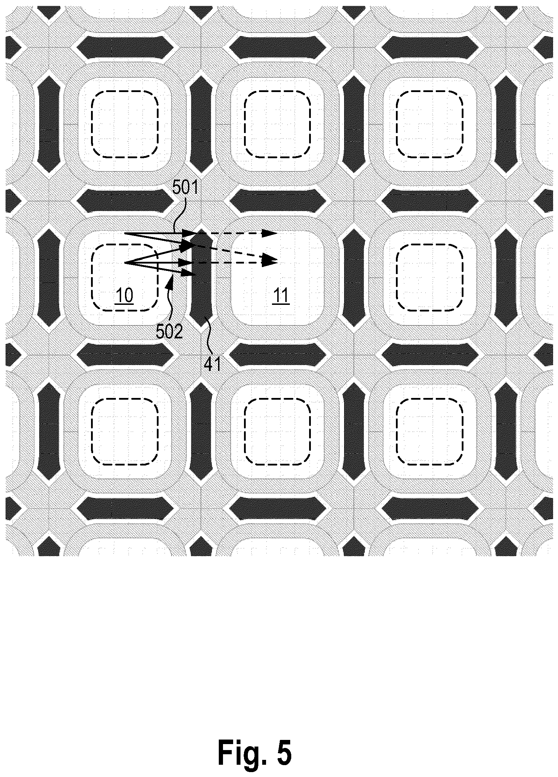

Referring to Fig. 5, a thickness of the blocking structure may optionally vary based on probability of a defect propagating from the first VCSEL 10 to the active area of the second VCSEL 11. Some potential propagation paths are illustrated by the sets of arrows 501 and 502. For a defect originating at an upper edge of the first VCSEL 10, a narrow tip at a top end of the blocking structure 41 may be sufficient, since the probability of defects hitting this part of the blocking structure is limited. However, a wider blocking region may be implemented towards a central portion of the blocking structure 41, since the probability of defects reaching this part of the blocking structure are higher.

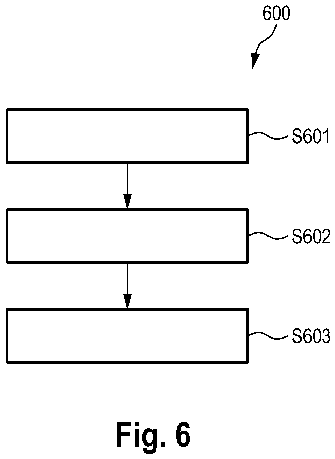

Fig. 6 shows a flow chart of a method 600 according to an aspect of the present invention. In a first step S601, a semiconductor die comprising a vertical layer stack adapted for fabrication of VCSELs is provided. In a second step S602, a crystal axis of the semiconductor die in a direction parallel to a surface of the semiconductor die and perpendicular to the vertical layer stack is determined. In a third step S603, the semiconductor die is processed as for example described with reference to Fig. 3A-3L into a semiconductor device comprising: a first VCSEL having a first active area; a second VCSEL having a second active area; wherein the first active area of the first VCSEL and the second active area of the second VCSEL are arranged along a first crystal axis; and a blocking structure arranged between the first VCSEL and the second VCSEL, wherein the blocking structure is adapted to block a propagation of a defect between the first VCSEL and the second VCSEL along the first crystal axis

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

A computer program may be stored/distributed on a suitable non-transitory medium, such as an optical storage medium or a solid-state medium supplied together with or as part of other hardware, but may also be distributed in other forms, such as via the Internet or other wired or wireless telecommunication systems.

Any reference signs in the claims should not be construed as limiting the scope.

## Claims

1. Semiconductor device (1) comprising an array of vertical cavity surface emitting lasers (10, 11, 12, 13), VCSELs, wherein the semiconductor device comprises:
- a first VCSEL (10) having a first active area (20);
- a second VCSEL (11) having a second active area (21);
- a bridge ((31, 31') connecting the first VCSEL and the second VCSEL;
wherein the first active area of the first VCSEL and the second active area of the second VCSEL are arranged along a first crystal axis (2); and
- a blocking structure (41) arranged between the first VCSEL (10) and the second VCSEL (11), wherein the blocking structure is adapted to block a propagation of a defect between the first VCSEL and the second VCSEL along the first crystal axis (2).

2. Semiconductor device according to claim 1, wherein the VCSEL array is a densely packed array having a pitch (p) of not more than 30µm, in particular not more than 20 µm, in particular not more than 17.5µm, in particular not more than 15µm, in particular not more than 10µm.

3. Semiconductor device according to any of the preceding claims, wherein a width (w₂) of the blocking structure (41) in a direction perpendicular to the first crystal axis (2) is wider than a width (w₁) of first and/or second active area in a direction perpendicular to the first crystal axis (2).

4. Semiconductor device according to any of the preceding claims, wherein a width (d₁) of the blocking structure (41) in a direction parallel to the first crystal axis is smaller than 30% or the VCSEL pitch, in particular smaller than 20% of the VCSEL pitch (p), in particular smaller than 10% of the VCSEL pitch, in particular smaller than 5% of the VCSEL pitch.

5. Semiconductor device according to any of the preceding claims, wherein the blocking structure (41) comprises an etched area; in particular wherein the blocking structure comprises a trench used for oxidation of the first and/or second VCSEL (10, 11).

6. Semiconductor device according to claim 5, wherein a depth of the etched area exceeds a depth of an active layer of the first and/or second VCSEL (10, 11).

7. Semiconductor device according to claim 5 or 6, wherein the etched area is separated from the top-contact (71, 72) of the first and/or second VCSEL.

8. Semiconductor device according to any of the preceding claims, wherein the bridge (31) connecting the first VCSEL (10) and the second VCSEL (11) bends around a side of the blocking structure (41).

9. Semiconductor device according to claim 8, wherein a second bridge (31') connecting the first VCSEL (10) and the second VCSEL (11) bends around a second side of the blocking structure (41) different from the first side.

10. Semiconductor device according to any of the preceding claims, wherein the bridge (31) connecting the first VCSEL (10) and the second VCSEL (11) is a bridge connecting the first VCSEL (10), the second VCSEL (11), a third neighboring VCSEL (12), and preferably further a fourth neighboring VCSEL (13).

11. Semiconductor device according to any of the preceding claims, wherein the first and second VCSEL (10, 11) of the array have a common top contact and/or common bottom contact.

12. Semiconductor device according to any of the preceding claims, further comprising
- a third VCSEL (12) having a third active area (22);
- a second bridge (32, 32') connecting the first VCSEL and the third VCSEL
wherein the first active area (20) of the first VCSEL and the third active area (22) of the third VCSEL are arranged along a second crystal axis (3); and
- a second blocking structure (42) arranged between the first VCSEL (10) and the third VCSEL (12), wherein the blocking structure is adapted to block a propagation of a defect between the first VCSEL and the third VCSEL along the second crystal axis (3).

13. Semiconductor device according to any of the preceding claims, wherein the first VCSEL (10) has a rectangular, in particular a quadratic active area, and wherein blocking structures are provided on each side of the active area.

14. Semiconductor device according to any of the preceding claims, wherein the semiconductor device (1) comprises a plurality of VCSELs (10, 11, 12, 13) arranged in rows and columns on a rectangular grid, in particular on a quadratic grid, and wherein a separate blocking structure (41, 42) is provided between each pair of neighboring VCSELs on the grid.

15. Method (600) of fabricating a semiconductor device comprising an array of vertical cavity surface emitting lasers (10, 11, 12, 13), VCSELs, the method comprising the steps of:
- providing a semiconductor die comprising a vertical layer stack adapted for fabrication of VCSELs (S601);
- determining a crystal axis of the semiconductor die in a direction parallel to a surface of the semiconductor die and perpendicular to the vertical layer stack (S602);
- processing (S603) the semiconductor die into a semiconductor device comprising:
- a first VCSEL having a first active area;
- a second VCSEL having a second active area;
wherein the first active area of the first VCSEL and the second active area of the second VCSEL are arranged along a first crystal axis; and
- a blocking structure arranged between the first VCSEL and the second VCSEL, wherein the blocking structure is adapted to block a propagation of a defect between the first VCSEL and the second VCSEL along the first crystal axis.
